Europäisches Patentamt

European Patent Office

Office européen des brevets

(19)

(11) **EP 1 178 602 A1**

(12) **EUROPEAN PATENT APPLICATION**

(43) Date of publication:
**06.02.2002 Bulletin 2002/06**

(51) Int Cl.$^7$: **H03F 1/22**

(21) Application number: **00402233.1**

(22) Date of filing: **04.08.2000**

(84) Designated Contracting States:
**AT BE CH CY DE DK ES FI FR GB GR IE IT LI LU MC NL PT SE**
Designated Extension States:
**AL LT LV MK RO SI**

(71) Applicant: **MOTOROLA, INC.**
**Schaumburg, IL 60196 (US)**

(72) Inventor: **Oliaei, Omid**
**31300 Toulouse (FR)**

(74) Representative: **Joly, Jean-Jacques et al**
**Cabinet Beau de Loménie 158, rue de l'Université**
**75340 Paris Cédex 07 (FR)**

(54) **Improved amplifier gain-boosting circuit**

(57) An amplifier gain-boosting circuit comprises first and second field effect transistors with the source of the first field effect transistor (Nc) being connected to the drain of the second field effect transistor (N1) so as to form a cascode amplifier stage, a first voltage input being connected to the gate of the second field effect transistor. A discrete time integrator (20) is connected between the gate of the first field effect transistor and the drain of the second field effect transistor, and a second reference voltage input is connected to the integrator whereby the drain voltage of the second transistor is forced by the said integrator to follow a reference voltage applied to the reference voltage input thereof when an input signal is applied to the first voltage input.

The invention is particularly suitable for use in low-power switched capacitor circuits.

*FIG. 3*

EP 1 178 602 A1

**Description**

This invention relates to an improved amplifier gain-boosting arrangement suitable for low voltage oversampling designs. The invention is particularly, but not exclusively, suitable for use in low-power switched capacitor circuits.

A wide variety of CMOS analogue circuits, such as switched capacitor filters, sigma-delta A/D converters, and dual slop integrators employ charge balancing in which an input signal is averaged (integrated) over a fixed time interval for a single measurement. The speed and the accuracy of analogue circuit are often the most important properties, and in CMOS analogue circuits such as those set out above, the speed and accuracy are determined by the settling behaviour of operational amplifiers. In particular, accurate settling of CMOS analogue circuits requires that there is a high dc gain, whereas fast settling requires a high unity-gain frequency and a single pole settling behaviour for the operational amplifier. These have traditionally been mutually exclusive requirements, and increasing the do gain to increase settling accuracy has been at the expense of settling time and vice versa.

A number of techniques have been proposed to enhance the dc gain of operational amplifiers, probably the best known of which is the so-called 'cascode' arrangement, in which two CMOS or other FET transistors are connected together so as to enhance the dc gain without degrading the high frequency performance which suffers from the Miller effect in a single FET transistor. Even with modern wafer technology, the maximum gain of a typical cascode arrangement is only 40-50dB, which is too low for many applications.

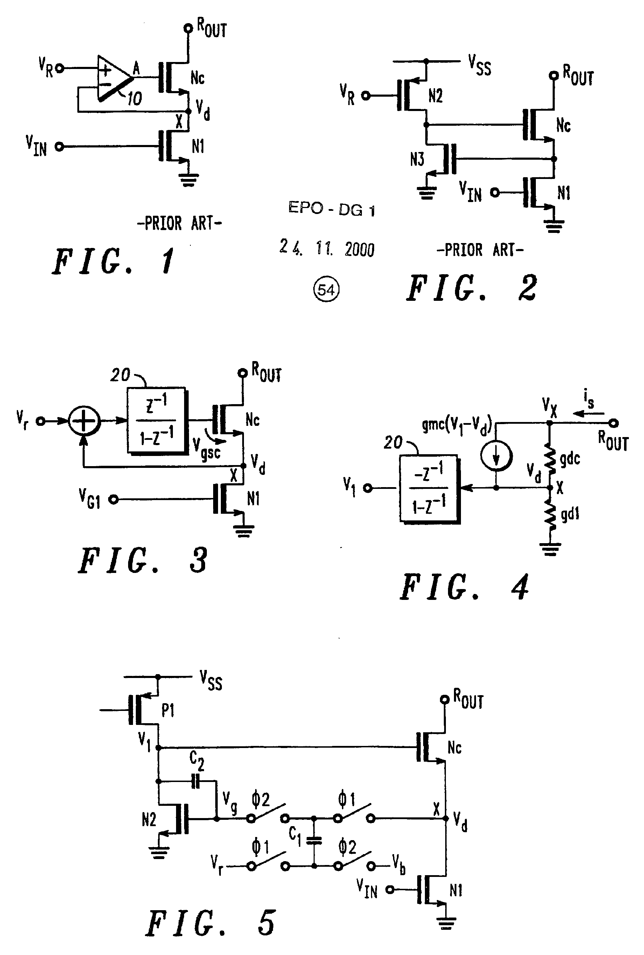

An improved arrangement for boosting the gain of the MOS amplifier employs dynamic biasing in the form of gain bootstrapping. This technique is often used with single-stage amplifiers, and particularly with cascode amplifiers as described above. The basic arrangement fixes the drain voltage of the MOS transistor at a reference voltage and is shown in Figure 1. The circuit includes a pair of cascode-arranged MOS transistor N1 and Nc with the source of the first transistor Nc connected directly to the drain of the second transistor N1. An operational amplifier 10 having a gain A has its inverting input connected to the source of Nc and the drain of N1, and the non-inverting input is connected to a reference potential $V_r$. The output of the operational amplifier is connected to the gate of the first transistor Nc.

This arrangement creates a local feedback and forces the voltage at the drain of N1, $V_d$, to follow the reference potential $V_r$. As a consequence, the output resistance $R_{out}$ of the circuit of Figure 1 is multiplied by a factor A. Thus, the output resistance is A times higher than the output resistance of a simple cascode circuit. Cascode circuits with the gate voltage controlled by a feedback amplifier are often known generically as regulated cascode or RGC circuits. The operational amplifier typically contains a large number of transistors and other components and is thus relatively expensive.

Figure 2 shows a simplified version of the schematic regulated cascode circuit of Figure 1 and is described, for example, in "A high swing, high impedance MOS Cascode Circuit", IEEE Journal of Solid State Circuits, Vol. 25 No. 1, February 1990 by E. Sackinger and W. Gugenbuhl. The circuit comprises a pair of transistors N1 and Nc in a cascode arrangement as in Figure 1. The operational amplifier is instead replaced by a second pair of FETs N2 and N3 with the reference voltage Vr being applied to the gate of the transistor N2 and the source of the transistor N2 being connected to the voltage rail $V_{ss}$. The drains of the two transistors N2 and N3 are connected together and also to the gate of the transistor Nc. Thus, the pair of transistors N2 and N3 together act as a simple amplifier, avoiding the expense of an operational amplifier.

The problem with such RGC circuits is that they are unsuitable for low-voltage applications, because the transistor N3 pulls up the drain-source voltage of the transistor N2, thus reducing the usable voltage swing at the output. In particular, the minimum output voltage is set by the gate-source voltage of the transistor N3 in combination with the drain-source voltage of the transistor Nc at saturation. For most applications Vgs(N3)≈0.8V and $V_{DS}$(Sat)(Nc) ≈ So the minimum output voltage is 0.8V+0.2Volt. This is too large for many low voltage applications.

It is an object of the present invention to address these problems with the prior art.

According to the present invention, there is provided an amplifier gain-boosting circuit comprising: first and second field effect transistor each having a gate, a source and a drain , the source of the first field effect transistor being connected to the drain of the second field effect transistor so as to form a cascode amplifier stage; a first voltage input connected to the gate of the second field effect transistor; and a second, reference voltage input; characterised by a discrete time integrator connected between the gate of the first field effect transistor and the drain of the second field effect transistor the second, reference voltage input being connected to the integrator whereby the drain voltage of the second transistor is forced by the said integrator to follow a reference voltage applied to the reference voltage input thereof when an input signal is applied to the first voltage input. The invention also extends to an amplifier gain boosting circuit comprising: first and second field effect transistors each of a first doping type, each having a gate, a source and a drain, the sources thereof each being connected to a current source and the gates thereof each being arranged to receive a common input voltage; and third and fourth field effect transistors each having a gate, a source and a drain, the third and fourth field effect transistors being of a second doping type different from the first doping type; the drain of the third transistor being connected to the drain of the first transistor and defining a first circuit node therebetween and the drain of the fourth transistor being connected to the drain of the second transistor and defining a second circuit node therebetween, the sources of the third and fourth transistors each being connected to ground, and the gates thereof connected to one another and defining a third circuit node therebtween; characterised by: a discrete time integrator connected between the first, second and third circuit nodes whereby, when a bias source voltage is applied to the integrator, the voltage at the first circuit node is actively boostrapped by the voltage at the second circuit node.

The invention may be put into practice in a number of ways, some embodiments of which will now be described by way of example only and with reference to the following Figures in which:

Figure 1 shows a schematic diagram of a prior art circuit for boosting the gain of an amplifier;
Figure 2 shows a simpler implementation of the prior art circuit of Figure 1;
Figure 3 shows a schematic diagram of a circuit embodying the present invention for boosting the gain of an amplifier;
Figure 4 shows the equivalent small-signal circuit of Figure 3;
Figure 5 shows a more detailed diagram of the circuit of Figure 3;
Figure 6 shows a further prior art circuit for boosting the gain of an amplifier;
Figure 7 shows a circuit embodying a second aspect of the present invention for boosting the gain of an amplifier;
Figure 8 shows the equivalent small signal circuit of Figure 7;
Figure 9 shows an alternative circuit embodying the second aspect of the present invention;
Figure 10a shows a plot of signal transfer function against normalized frequency for a basic amplifier, the prior art circuits of Figures 2 and 6 and for the circuit of Figure X; and
Figure 10b shows a plot of noise transfer function against normalized frequency for a basic amplifier, the prior art circuits of Figures 2 and 6, and for the circuit of Figure X.

Referring first to Figure 3, a schematic circuit diagram illustrating the principles of the present invention is shown. As with the prior art arrangement of Figure 1, a pair of transistors Nc, N1 are connected to form a cascode with the source of transistor Nc connected with the drain of transistor N1. However, instead of using an amplifier to regulate the cascode, a unity gain discrete-time integrator is instead used to feed back signals between the drain of the transistor N1 and the gate of the transistor Nc.

As seen in Figure 3, the potential at the point X between the source of the transistor Nc and the drain of the transistor N1 is subtracted from a reference voltage $V_r$, the resultant signal being fed via a unity gain discrete time integrator 20 to the gate of the transistor Nc. Similarly to the amplifier 10 of Figure 1, the feedback loop tries to fix the drain voltage $V_d$ of the transistor N1 at the reference voltage. However, because the integrator 20 operates in the discrete-time domain, the voltage $V_d$ is not tightly locked to the voltage $V_r$. Instead, the voltage at the point X has some freedom to vary, so that $V_d$ tends to $V_r$ over several periods. At higher frequencies, the voltage at the point X is unable to follow the reference voltage and the integrator 20 acts to present a high gain only at low frequencies. However, there are a number of circuits which employ low frequency signals, such as sigma-delta analogue-to-digital (A/D) converters. The circuit of Figure 3 thus finds particular application in these circuits, where the twin advantages of lower cost components and ability to operate at low voltages are achieved without compromising the gain which would be necessary if operated at high frequencies.

The large signal operation of the circuit of Figure 3 can be analysed as follows. It may be assumed that the (drain-source) current in the transistors is fixed by the gate-source voltage of N1, and since the source of transistor N1 is grounded, this simply $V_{G1}$, which may be taken to be constant. If the gate-source voltage of transistor Nc is $V_{gsc}$, then it is apparent that:

$$(V_r - V_d)\left(\frac{z^{-1}}{1 - z^{-1}}\right) - V_{gsc} = V_d \qquad (1)$$

where $Z^{-1} \equiv e^{-j\omega t}$ and T is the period of one clock cycle.

This may be rearranged and simplified to show:

$$V_d = V_r z^{-1} - V_{gsc}(1 - z^{-1}) \qquad (2)$$

As $z^{-1} \to 1$, $V_d \to V_r$ for low frequencies.

In other words, any voltage variation at X tends to zero after several clock periods because of the feedback loop, in the manner of a damped oscillator.

Figure 4 shows the small-signal equivalent circuit of the circuit of Figure 3. The transistor $N_c$ is shown in terms of its equivalent circuit for small signals, the transistor N1 can be represented by a conductance $g_{d1}$ and the reference voltage $V_r$ is set to zero. Then by inspection.

$$g_{mc}\left(\frac{-z^{-1}}{1-z^{-1}}-1\right)v_d + g_{mc}(v_r - v_d) = g_{d1}v_d = i_s \tag{3}$$

whence:

$$\frac{v_x}{i_x} = \frac{1}{g_{d1}}\frac{g_{d1} + g_{dc} + g_{mc}}{g_{dc}}\frac{1-\left(\frac{g_{d1} + g_{dc}}{g_{d1} + g_{dc} + g_{mc}}\right)z^{-1}}{1-z^{-1}} \tag{4}$$

$1/g_{d1}$ represents the output resistance of the transistor $N_c$ (which acts as a current source), $(g_{d1}+g_{dc}+g_{mc})/g_{dc}$ is the effect of resistance enhancement due to cascoding, and the remaining factor represents the gain boosting effect. If $A_b$ is defined as:

$$A_b = \frac{g_{d1} + g_{dc} + g_{mc}}{g_{d1} + g_{dc}} \tag{5}$$

and $A_c$ is defined as:

$$A_c = \frac{g_{d1} + g_{dc} + g_{mc}}{g_{dc}} \tag{6}$$

then

$$R_{out}(z) = \frac{1}{g_{d1}}A_c\frac{1-(z^{-1}/A_b)}{1-z^{-1}} \tag{7}$$

Thus, the steady state resistance of the circuit of Figure 3, $R_{out}$, tends to infinity as $Z_n^{-1}\rightarrow1$. If a voltage impulse is applied to the circuit, then the current will tend to zero after several clock cycles. The small signal model is of course only an approximation, so that in reality the integrator does not have infinite DC gain and $R_{out}$ does not become infinite. It is nonetheless significantly higher than that of an operational amplifier (denoted as A in Figure 1) which in turn improves the stability of circuits incorporating this feature.

Turning now to Figure 5, a more detailed circuit diagram of the circuit of Figure 3 is shown, indicating one simple way in which the gain boosting arrangement of Figure 3 can be implemented.

The circuit of Figure 5 includes first and second transistors, Nc and N1. arranged as with the circuit of Figure 3 as a cascode with the source of transistor Nc connected to the drain of transistor N1. The integrator 20 of Figure 3 is implemented with a pair of transistors P1 and N2 and with first and second capacitors $C_1$ and $C_2$ respectively, to form the well-known switched capacitor integrator. The transistor P1 is a p-type transistor whose source is connected to the voltage rail $V_{ss}$, with the drain thereof connected to the drain of an n-type transistor N2. The drain of the transistor P1 is additionally connected to the gate of the transistor Nc which forms part of the cascode structure. Furthermore, a feedback capacitor $C_2$ is connected between the drain of transistor N2 and its gate.

The gate of the transistor N2 is connected via two switches to a point X along the connection between the source of the transistor Nc and the drain of the transistor N1. The switches are shown for the sake of clarity in Figure 5 as simple mechanical switches labelled $\phi_1$ and $\phi_2$. It will be appreciated that, in fact, switching is typically carried out using MOSFETs, and that during a first clock phase $\phi$, the switch labelled $\phi_1$, is closed and the switch labelled $\phi_2$ is

open, whereas the reverse applies during a second clock phase $\phi_2$.

Two voltages, $V_r$ and $V_b$ are used as inputs to the circuit. $V_r$ is a reference voltage. One or other of these voltages is switched into the circuit during the clock phases $\Phi_1$ and $\Phi_2$ via a capacitor $C_1$.

The transistors N2 and P1 operate as a simple amplifier. During a clock phase $\phi_1$, the voltage at the node X is sampled, and during a clock phase $\phi_2$, it is integrated. It will be appreciated that the circuit of Figure 5 needs to be clocked with the same clock phase scheme as any amplifier which employs this circuit.

Since, during the integration phase $\phi_2$, the source of the transistor Nc is not connected to the capacitor $C_1$, $C_1$ has no effect on the amplifier phase margin and its settling performance. By choosing $C_1 = C_2$, the integrator presents unity gain. The recursion equation which describes the circuit time behaviour may be written as:

$$C_1[V_r - V_d(n - 1)] + C_2[V_1(n - 1) - V_g(n - 1)] = C_1[V_b - V_g(n)] + C_2[V_1(n) - V_g(n)] \tag{8}$$

At steady state, voltages settled to their final value: $V_1(n) = V_1(n-1)$ and $V_g(n) = V_g(n-1)$. Setting $C_1 = C_2$, it may be shown that:

$$V_d = V_r - V_b + V_g \tag{9}$$

where $V_d$ is the drain voltage of the transistor N1 (and also the voltage at the node X) and $V_g$ is the gate voltage of the transistor N2. By choosing $V_b = V_g$, the drain voltage of the transistor N1 can be fixed at $V_d = V_r$. The voltage $V_b$ can easily be generated by a branch circuit (not shown) composed of identical transistors to transistor N2 and transistor P1. In other words, at steady state. when the voltages in the circuit have settled to their final values, the drain of the transistor N1 in the cascode arrangement is held at the reference voltage, as in the prior art circuits of Figures 1 and 2. It will however immediately be apparent that the drain voltage of the transistor N1 in Figure 2 is fixed by the gate voltage of the transistor N3 and thus the minimum output voltage of that circuit is typically around 1 Volt. In the circuit of Figure 5, by contrast, the drain voltage of the transistor N1 may be at a lower voltage than the voltage Vg at the gate of the transistor N2, $V_d$ usually being sufficient to ensure the saturation of transistor N1. In other words, the minimum output voltage of the circuit of Figure 5 is approximately $2V_d(sat) \approx 0.4$ Volts.

The circuit of Figure 5 is thus particularly suitable for low-voltage applications. If the gain of the amplifier comprising the transistors N2 and P1 is supposed to be infinity, and charge injection error due to the switches is neglected, then a loss-free integrator having unity gain is presented as a feedback loop between the gate of the transistor Nc and the node X. In reality, of course, the integrator is leaky due to the finite gain presented by the transistors N2 and P1. More specifically, the gain $A_r$ of the amplifier composed of N2 and P1 is given by:

$$A_r = \frac{g_{m2}}{g_{dN2} + g_{dP2}} \tag{10}$$

Thus, the transfer function H(z) of the integrator is modified from $z^{-1}/(1-z^{-1})$ to

$$H(z) = \frac{\dfrac{C_1}{C_2}\left[1 + \dfrac{1 + C_1/C_2}{A_r}\right]z^{-1}}{1 - \dfrac{1 + (1/A_r)}{\left[1 + \dfrac{1 + C_1/C_2}{A_r}\right]}z^{-1}} \tag{11}$$

By setting $C_1 = C_2$, and neglecting mismatch between them, Equation 11 approximates to:

$$H(z) = \frac{\left[1 + \dfrac{2}{A_r}\right]z^{-1}}{1 - \left[1 - \dfrac{1}{A_r}\right]z^{-1}} \qquad (12)$$

By inserting the above-derived transfer function for an integrator with non-infinite amplifier gain into Equation 3 derived above, the small signal equivalent output resistance of the circuit, $R_{out}(z)$ may be obtained:

$$R_{out}(z) = \frac{1}{g_{d1}} A_c \frac{1 - \left[\dfrac{1}{A_b} - \dfrac{3}{A_r}\right]z^{-1}}{1 - \left[1 - \dfrac{1}{A_r}\right]z^{-1}} \qquad (13)$$

The steady state output resistance may be determined from Equation 13 by setting z to 1, wherein:

$$R_{out} \rightarrow \frac{1}{g_{d_1}} A_c A_r \qquad (14)$$

This is exactly the output resistance of the regulated cascode circuit of Figure 2.

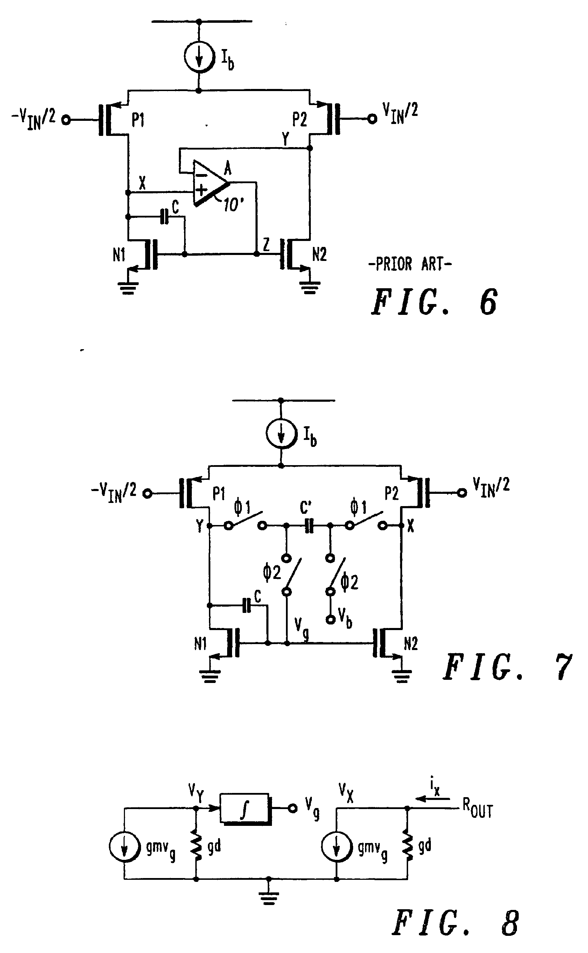

The principles described above may advantageously be applied to many different circuits. One such circuit where the use of oversampling is particularly effective is in the so-called active-bootstrapped gain enhancement circuit of Figure 6. The operation of this circuit is described in "Active-bootstrapped Gain-enhancement Technique for Low-voltage Circuits", IEE Transactions on Circuit and Systems - II, vol. 45, no. 9, September 1998, by I.E. Seevinck et al, which is incorporated herein by reference in its entirety. The circuit will not be described herein in greater detail, therefore. Figure 7 shows how a relatively cheap unity gain integrator can be inserted into the circuit rather than the operational amplifier 10' shown in Figure 6.

As seen in Figure 7, the circuit comprises two P-type transistors, P1 and P2 whose sources are connected to a current source $I_b$. The drain of the transistor P1 is connected to the drain of an N-type transistor N1, and the drain of the transistor P2 is connected to the drain of another P-type transistor N2. The gate of transistor P2 is connected to an input voltage Vin/2, the inverse of which (-Vin/2) is applied to the gate of transistor P1.

The sources of the two N-type transistors N1 and N2 are each connected to a common ground. The gates of the two N-type transistors are connected together. The drain of the transistor N1 is connected via feedback capacitor C to the gate thereof.

The capacitor switching arrangement, again shown schematically as simple mechanical switches, is arranged between the line connecting the gates of the two transistors N1 and N2, and circuit nodes x and y. Node x lies on the connection between the drain of the transistor P2 and the drain of the transistor N2, and node y lies on the connection between the drain of the transistor P1 and the drain of the transistor N1. In a first clock phase $\phi_1$, the node y is connected to the node x via a capacitor C'. In a second clock phase, however, a voltage $V_b$ is connected to the gates of the two transistors N1 and N2 via the capacitor C'. It will be appreciated that, nominally, the capacitance of the capacitor C' is the same as the capacitance of the capacitor C, with the two being labelled differently simply for the purposes of explanation of the circuit.

The transistors N1 and P1 provide the amplifier for the integrator in the circuit of Figure 7. The capacitor C' acts as the integration capacitor. As with the circuit of Figure 5, the bias source voltage $V_b$ is equal to the steady state gate-source voltage of the transistors N1 and N2.

The recursion equation for the circuit of Figure 7 is:

$$[V_x(n-1) - V_y(n-1)] + [V_y(n-1) - V_g(n-1)] = [V_b(n) - V_g(n)] + [V_x(n) - V_g(n)] \qquad (15)$$

Again, at steady state $V_g(n) = V_g(n-1)$, and when $V_b = V_g(\infty)$, $V_y = V_x$.

The small signal equivalent circuit for Figure 7 is shown in Figure 8. The recursion equation for this circuit is :

$$[v_y(n-1) - v_x(n-1)] + [v_y(n-1) - v_x(n-1)] = [-v_x(n)] + [v_y(n) - v_x(n)] \qquad (16)$$

Two node equations may also be written down:

$$g_m v_g + g_d v_y = 0 \qquad (17)$$

$$g_m v_g + g_d v_y = i_x \qquad (18)$$

Taking the z-transform of Equation 16, the resulting system of equations can be resolved to obtain an expression for $R_{out}(z)$:

$$R_{out}(z) = \frac{1}{g_d} \frac{1 - \left[\dfrac{1}{2 + A_r}\right] z^{-1}}{1 - \left[\dfrac{1 + A_r}{2 + A_r}\right] z^{-1}} \qquad (19)$$

where $A_r$ is defined as:

$$A_r = g_m / g_d \qquad (20)$$

The DC output resistance (that is, the output resistance at steady state) is obtained once again by setting $z = 1$:

$$R_{out} = (1 + A_r)/g_d \qquad (21)$$

In other words, at steady state the output resistance of the circuit of Figure 7 is multiplied by the gain of the amplifier, where the amplifier is composed of the transistors N1 (N2) and P1 (P2). This is exactly the output resistance of the amplifier of Figure 6 when A = 1, as has been shown in the above-referenced Journal Article by Seevinck et al.

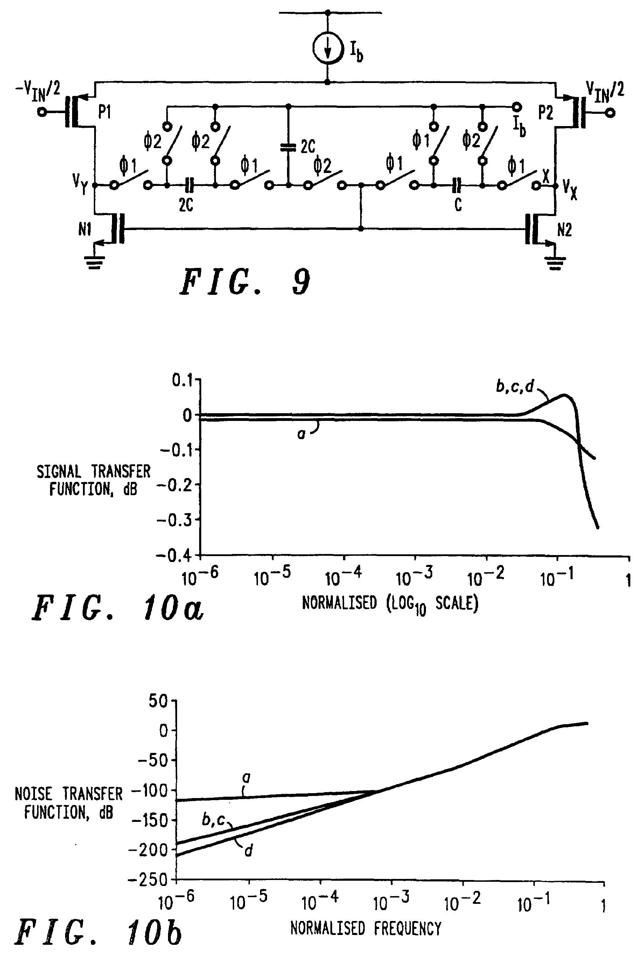

Figure 9 shows an alternative active bootstrapping circuit, again employing the oversampling gain boosting techniques of the invention. The circuit of Figure 9 is similar to the circuit of Figure 7, except that a different arrangement of switch capacitors is used. As with the circuit of Figure 7, the switched capacitor arrangement is connected between circuit nodes x and y, and the connection between the gates of the transistors N1 and N2. In a first clock phase $\phi_1$, however, the bias source $V_b$ is connected into the circuit. The node y is connected to the node x via two capacitors of capacitance 2C and a further capacitor of capacitance C each of which is in series with the bias source $V_b$. In the second clock phase $\phi_2$, the bias source $V_b$ is decoupled from the two circuit nodes x and y, and is instead connected to the line between the gates of the two transistors N1 and N2 via the three capacitors of capacitances 2C, 2C and C respectively which are this time in parallel. An input voltage $V_{in}/2$ is applied to the gate of transistor P2 on the right-hand side of the circuit of Figure 9, and an input voltage of $-V_{in}/2$ is applied to the gate of transistor P1 on the lefthand side of that circuit. Thus, the left-hand side of the circuit represents a non-inverting integrator, whereas the right-hand side represents an inverting integrator. The output resistance of the circuit of Figure 9 is also given by the expression of Equation 19.

One important practical application of the oversampled gain-boosting technique described above is in the well-known sigma-delta modulator or A/D converter which has a low frequency clock input already present. The sigma-delta modulator is particularly useful in digital signal processors (DSPs) found in many modern electronic devices and typically used for high speed digital filtering. Expressions for the DC-gain of an oversampled regulated cascode arrangement and oversampled active bootstrapped circuit have been derived above. If the DC-gain of the basic amplifier is represented by $A_0$, then the gain $A_E(z)$ of the enhanced amplifier of Figure 3 is ideally given by

$$A_E(z) = A_0 \; \frac{1 - z^{-1}/A_b}{1 - z^{-1}} \tag{22}$$

where $A_b$ is defined as in Equation 5. For the oversampled regulated-cascode circuit of Figure 5, and taking into account the finite gain of the boosting amplifier,

$$A_E(z) = A_0 \; \frac{1 - \left[\dfrac{1}{A_b} - \dfrac{3}{A_r}\right] z^{-1}}{1 - \left[1 - \dfrac{1}{A_r}\right] z^{-1}} \tag{23}$$

where again $A_0$ is the DC-gain of the prior art circuit (Figure 2), $A_b$ is defined in Equation 5, and $A_r$ is defined in Equation 10. Finally, in the case of the oversampled active-bootstrapped circuit of Figure 7 and Figure 9, the gain of the enhanced amplifier is:

$$A_E(z) = A_0 \; \frac{1 - \left[\dfrac{1}{2 + A_r}\right] z^{-1}}{1 - \left[\dfrac{1 + A_r}{2 + A_r}\right] z^{-1}} \tag{24}$$

with $A_r$ again defined in Equation 10. Each of these expressions are similar to the corresponding expressions derived for the output resistances of the corresponding circuits in Equations 7, 13 and 19.

Figures 10a and 10b show, respectively, the signal transfer function in decibels and the noise transfer function, also in decibels, versus normalized frequency, on a logarithmic scale, for the circuits of Figure 1, Figure 2, and Figure 5. More particularly, in each of Figures 10a and 10b the plot labelled (a) represents the basic amplifier of Figure 1 with a gain of $A_0 = 500$, (b) is the dynamic cascode-regulated circuit of Figure 2 with $A_0 = 500$, $A_b = 100$ and $A_r = 100$, (c) is the active-bootstrapped amplifier circuit of Figure 5 with the same values for $A_0$, $A_b$ and $A_r$, and (d) is the enhanced amplifier of Figure 3, with $A_0 = 500$, $A_b = 100$ and $A_r = \infty$. It will be appreciated that, in the limit of $A_r = \infty$, the Equation 23 tends to the Equation 22.

Figure 10b shows that the noise floor of the enhanced amplifier of Figure 3 is significantly lower than that of the prior art amplifiers, at low frequencies. Figure 10a indicates that signal attenuation is prevented. In fact, this is true even when $a_r$ finite.

Although a number of embodiments have been described, it will be appreciated that the oversampling techniques can be applied to other circuits to enhance the gain at lower cost and/or complexity than previously.

**Claims**

1.   An amplifier gain-boosting circuit comprising:

first and second field effect transistor each having a gate, a source and a drain , the source of the first field effect transistor being connected to the drain of the second field effect transistor so as to form a cascode amplifier stage;
a first voltage input connected to the gate of the second field effect transistor; and
a second, reference voltage input; **characterised by**
a discrete time integrator connected between the gate of the first field effect transistor and the drain of the second field effect transistor;

the second, reference voltage input being connected to the integrator whereby the drain voltage of the second transistor is forced by the said integrator to follow a reference voltage applied to the reference voltage input thereof when an input signal is applied to the first voltage input.

2. The circuit of claim 1, in which the discrete time integrator has unity gain.

3. The circuit of claim 1 or claim 2, in which the discrete time integrator is a switched capacitor integrator.

4. The circuit of claim 1, in which the discrete time integrator includes:

a third field effect transistor being one of p-type or n-type and having a source, a drain and a gate;
a fourth field effect transistor being the other of p-type or n-type; and having a source, a drain and a gate the drain of the third transistor being connected to the drain of the fourth transistor, such that the third and fourth transistors define between them an amplifier stage;
a first capacitor connected between the gate of the fourth transistor and the drain thereof;
a second capacitor; and
switching means;

the reference voltage applied to the integrator being time varying, and the switching means causing the reference voltage to be connected to the drain of the second field effect transistor via the second capacitor during a first phase of the time varying reference voltage, and causing a voltage of amplitude equivalent to the voltage at the gate of the said fourth field effect transistor to be connected via the second capacitor to the gate of the fourth transistor during a second phase of the time varying reference voltage.

5. The circuit of claim 4, in which the third transistor is a p-type field effect transistor, and the fourth transistor is an n-type field effect transistor

6. An amplifier gain boosting circuit comprising: first and second field effect transistors each of a first doping type, each having a gate, a source and a drain, the sources thereof each being connected to a current source and the gates thereof each being arranged to receive a common input voltage; and

third and fourth field effect transistors each having a gate, a source and a drain, the third and fourth field effect transistors being of a second doping type different from the first doping type; the drain of the third transistor being connected to the drain of the first transistor and defining a first circuit node therebetween and the drain of the fourth transistor being connected to the drain of the second transistor and defining a second circuit node therebetween, the sources of the third and fourth transistors each being connected to ground, and the gates thereof connected to one another and defining a third circuit node therebtween;
**characterised by**:

a discrete time integrator connected between the first, second and third circuit nodes whereby, when a bias source voltage is applied to the integrator, the voltage at the first circuit node is actively boostrapped by the voltage at the second circuit node.

7. The circuit of claim 6, in which the discrete time integrator has unity gain.

8. The circuit of claim 6 or claim 7, in which the discrete time integrator is a switched capacitor integrator.

9. The circuit of claim 8, in which the integrator includes a first capacitor connected between the drain and gate of one of the third and fourth transistors.

10. The circuit of claim 9, in which the integrator further comprises a second capacitor connected between the first and second circuit nodes, and a plurality of switching means; the bias source voltage being time varying and the switching means causing the first circuit node to be connected to the second node via the second capacitor during a first phase of the time varying bias source voltage, and for the bias source voltage to be connected to the third circuit node via the said second capacitor during a second phase of the time varying bias source voltage.

11. The circuit of claim 8, in which the integrator comprises a first capacitor of capacitance C, a second capacitor of capacitance 2C, a third capacitor of capacitance 2C, and switching means, the bias source voltage being time

EP 1 178 602 A1

varying and the switching means causing the first circuit node to be connected to the second circuit node via a series connection of the first, second and third capacitors and the bias source voltage to be connected between the first and second circuit nodes during a first phase of the said time varying bias source voltage and causing the bias source voltage to be connected to the third circuit node via a parallel connection of the first, second and third capacitors.

12. The circuit of any of claims 6 to 11, in which the first and second Transistors are each p-type and the third and fourth transistors are each n-type.

13. A sigma-delta analog-to-digital converter including the circuit of any preceding claim.

$R_{OUT}$

$V_R$

$A$

$Nc$

$10$

$V_d$

$X$

$V_{IN}$

$N1$

-PRIOR ART-

# FIG. 1

EPO - DG 1

24. 11. 2000

(54)

$V_{SS}$

$V_R$

$N2$

$R_{OUT}$

$Nc$

$N3$

$V_{IN}$

$N1$

-PRIOR ART-

# FIG. 2

$20$

$R_{OUT}$

$V_r$

$$\frac{Z^{-1}}{1-Z^{-1}}$$

$Nc$

$V_{gsc}$

$V_d$

$X$

$V_{G1}$

$N1$

# FIG. 3

$gmc(V_1-V_d)$

$V_X$

$i_s$

$20$

$$\frac{-Z^{-1}}{1-Z^{-1}}$$

$R_{OUT}$

$V_1$

$gdc$

$V_d$

$X$

$gd1$

# FIG. 4

$V_{SS}$

$P1$

$R_{OUT}$

$V_1$

$Nc$

$C_2$

$V_g$

$\phi2$

$\phi1$

$X$

$V_d$

$N2$

$C_1$

$\phi1$

$\phi2$

$V_r$

$V_b$

$V_{IN}$

$N1$

# FIG. 5

-PRIOR ART-

*FIG. 6*

*FIG. 7*

*FIG. 8*

FIG. 9

FIG. 10a

FIG. 10b

**European Patent Office**

## EUROPEAN SEARCH REPORT

Application Number

EP 00 40 2233

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | COPELAND M A ET AL: "DYNAMIC AMPLIFIER FOR M.O.S., TECHNOLOGY" ELECTRONICS LETTERS,GB,IEE STEVENAGE, vol. 15, no. 10, 10 May 1979 (1979-05-10), pages 301-302, XP000575326 ISSN: 0013-5194 | 1-5 | H03F1/22 |
| A | * the whole document * | 6-10 | |
| Y | HELFENSTEIN M ET AL: "90DB, 90MHZ, 30MW OTA WITH THE GAIN-ENHANCEMENT IMPLEMENTED BY ONE-AND TWO-STAGE AMPLIFIERS" INTERNATIONAL SYMPOSIUM ON CIRCUITS AND SYSTEMS (ISCAS),US,NEW YORK, IEEE, 30 April 1995 (1995-04-30), pages 1732-1735, XP000559036 ISBN: 0-7803-2571-0 * page 1732 - page 1733; figure 3 * | 1-5 | |
| A | SHIH C -C ET AL: "A CMOS 5-V ANALOG FRONT END FOR 9600-BIT/S FACSIMILE MODEMS" IEEE JOURNAL OF SOLID-STATE CIRCUITS,US,IEEE INC. NEW YORK, vol. SC-22, no. 6, 1 December 1987 (1987-12-01), pages 990-995, XP000050546 ISSN: 0018-9200 * page 992 - page 993; figures 4,5 * | 1,6, 11-13 | **TECHNICAL FIELDS SEARCHED (Int.Cl.7)** H03F |
| D,A | SACKINGER E ET AL: "A HIGH-SWING, HIGH-IMPEDANCE MOS CASCODE CIRCUIT" IEEE JOURNAL OF SOLID-STATE CIRCUITS,US,IEEE INC. NEW YORK, vol. 25, no. 1, 1 February 1990 (1990-02-01), pages 289-298, XP000101879 ISSN: 0018-9200 * the whole document * | 1 | |

The present search report has been drawn up for all claims

| Place of search | Date of completion of the search | Examiner |
|---|---|---|
| THE HAGUE | 22 November 2000 | Tyberghien, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)